# EUROPEAN PATENT APPLICATION

(11) **EP 3 945 140 A1**
(43) Date of publication of application: **02.02.2022**
(21) Application number: 21188407.7
(22) Date of filing: 29.07.2021
(51) Int. Cl.: C23C 14/04, C23C 14/22, G03F 1/22, H01L 51/00

(54) **MASK AND METHOD OF MANUFACTURING THE SAME**

(30) Priority: 31.07.2020 KR 20200095824
(71) Applicant: Samsung Display Co., Ltd., Gyeonggi-Do (KR)
(72) Inventor: KIM, Jeongkuk, Suwon-si (KR); KIM, Hwi, Suwon-si (KR); LEE, Areum, Suwon-si (KR); JEONG, Da-Hee, Seoul (KR); HWANG, Kyu Hwan, Seongnam-si (KR); NAM, Kanghyun, Asan-si (KR); JIN, Seungmin, Cheonan-si (KR); HONG, Jaemin, Seongnam-si (KR)
(74) Representative: Shearman, James Ward

(57) **Abstract**

A mask includes a mask sheet provided with a plurality of open areas defined therein in a plan view and a mask frame which supports the mask sheet. The mask sheet includes a first portion including a first surface, where the first surface is configured to be in contact with a target substrate, and a second portion disposed on the first portion, extending from a top of the first portion in a first direction and including a second surface defining the open area. The second surface is an inclined surface inclined downward with respect to the first direction, and the first direction is parallel to a plane in which the first surface is included.

## Description

### BACKGROUND

### 1. Field of disclosure

The present disclosure relates to a mask and a method of manufacturing the same. More particularly, the present disclosure relates to a mask having improved process yield and reliability and a method of manufacturing the mask.

### 2. Description of the Related Art

A display panel includes a plurality of pixels. Each of the pixels includes a driving device, such as a transistor, and a display device, such as an organic light emitting diode. The display device is formed by stacking an electrode and a light emission pattern on a substrate.

The light emission pattern is patterned using a mask through which holes are defined, and thus, the light emission pattern is formed in predetermined areas exposed through the holes. The light emission pattern has a shape determined by a shape of the holes.

### SUMMARY

The present disclosure provides a mask having improved reliability in a deposition process, having reduced manufacturing process cost and time, having improved precision in the deposition process, and having reduced dead space caused by a shadow.

The present disclosure provides a method of manufacturing the mask.

Embodiments of the inventive concept provide a mask including a mask sheet provided with a plurality of open areas defined therein in a plan view and a mask frame which supports the mask sheet. The mask sheet includes a first portion including a first surface, where the first surface is configured to be in contact with a target substrate, and a second portion disposed on the first portion, extending from a top of the first portion in a first direction and including a second surface defining the open area. The second surface is an inclined surface inclined downward with respect to the first direction, and the first direction is parallel to a plane in which the first surface is included.

The inclined surface may have an inclination angle from about 30 degrees to about 70 degrees.

The mask sheet may have a coefficient of thermal expansion equal to or smaller than about 5 parts per million per degree Centigrade (ppm/°C).

The mask frame may have a coefficient of thermal expansion that is the same as the coefficient of thermal expansion of the mask sheet.

The mask sheet may have a thickness from about 20 micrometers (µm) to about 200 µm in a thickness direction of the mask sheet.

The first portion may have a thickness smaller than a half of a thickness of the mask sheet.

The inclined surface may have an inclination angle equal to or smaller than a deposition incident angle, and the deposition incident angle may be an angle at which a deposition material to be deposited on the target substrate is provided to the mask sheet.

The mask sheet may include an alloy of iron (Fe) and nickel (Ni).

The plurality of open areas may include a first open area and a second open area defined adjacent to the first open area, and the second surface may include two second surfaces that define the first open area and the second open area, respectively.

The two second surfaces may be disposed to be symmetrical with each other with respect to the first portion.

Embodiments of the inventive concept provide a mask including a mask sheet provided with a plurality of open areas defined therein in a plan view and a mask frame which supports the mask sheet. The mask sheet includes a first surface that is configured to be in contact with a target substrate and a second surface disposed above the first surface and defining the open areas. The second surface is an inclined surface inclined downward with respect to a first direction, and the first direction is parallel to a plane in which the first surface is included.

The inclined surface may have an inclination angle from about 30 degrees to about 70 degrees.

The mask sheet may have a thickness equal to or smaller than about 100 µm in a thickness direction of the mask sheet.

The mask sheet may have a coefficient of thermal expansion equal to or smaller than about 5 ppm/°C.

The mask sheet may be configured to deposit a same thin film layer of a same material on a base substrate of an organic light emitting diode over an individual display device.

The mask sheet may further include a third surface defined between the first surface and the second surface, and the third surface has a length, in the thickness direction, equal to or smaller than a half of a thickness of the mask sheet.

Embodiments of the inventive concept provide a method of manufacturing a mask. The manufacturing method of the mask includes forming a mask sheet, tensioning the mask sheet, and coupling the mask sheet to a mask frame. The forming of the mask sheet includes preparing a preliminary mask sheet and irradiating a laser beam onto the preliminary mask sheet to form a plurality of open areas. The open areas are defined by an inner side surface of the mask sheet, and the inner side surface is an inclined surface with respect to a major surface plane of the mask sheet.

The inclined surface may have an inclination angle from about 30 degrees to about 70 degrees.

The mask sheet may be configured to deposit a same thin film layer of a same material on a base substrate of an organic light emitting diode over an individual display device.

The mask sheet and the mask frame may have a coefficient of thermal expansion equal to or smaller than about 5 ppm/°C.

Embodiments of the inventive concept provide a mask including a mask sheet provided with a plurality of open areas to stack a plurality of thin film layers of a same material on a target substrate and a mask frame which supports the mask sheet. The mask sheet includes a first portion including a first surface, wherein the first surface is configured to be in contact with the target substrate and a second portion disposed on the first portion, extending from a top of the first portion in a first direction and including a second surface defining the open areas. The second surface is an inclined surface inclined downward with respect to the first direction, the first direction is parallel to a plane in which the first surface is included, and the inclined surface has an inclination angle from about 30 degrees to about 70 degrees.

According to the above, the precision is improved when forming a display panel, and a formation of a shadow is prevented. A display panel manufactured using the mask according to the present disclosure has reduced dead space, and defects are effectively prevented in the display panel.

The above and other features of the invention are set out in the appended claims.

### BRIEF DESCRIPTION OF THE DRAWINGS

The above and other advantages of the present disclosure will become readily apparent by reference to the following detailed description when considered in conjunction with the accompanying drawings wherein:
FIG. 1 is an exploded perspective view showing a mask according to an embodiment of the present disclosure;
FIG. 2 is a plan view showing a mask sheet according to an embodiment of the present disclosure;
FIGS. 3A and 3B are cross-sectional views showing a mask sheet according to an embodiment of the present disclosure;
FIG. 4 is an enlarged view showing an area BB' of FIG. 3A;
FIG. 5 is a cross-sectional view showing a mask sheet according to an embodiment of the present disclosure;
FIG. 6 is an enlarged view showing an area CC' of FIG. 5;
FIG. 7A is a cross-sectional view showing a mask sheet according to a comparative example;
FIG. 7B is an enlarged view showing an area DD' of FIG. 7A; and
FIGS. 8A and 8B are SEM images showing a deposition portion formed using a mask according to an embodiment of the present disclosure.

### DETAILED DESCRIPTION

In the present disclosure, it will be understood that when an element or layer is referred to as being "on", "connected to" or "coupled to" another element or layer, it can be directly on, connected or coupled to the other element or layer or intervening elements or layers may be present.

Like numerals refer to like elements throughout. In the drawings, the thickness, ratio, and dimension of components are exaggerated for effective description of the technical content. As used herein, the term "and/or" includes any and all combinations of one or more of the associated listed items.

It will be understood that, although the terms first, second, etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present disclosure. As used herein, the singular forms, "a", "an" and "the" are intended to include the plural forms as well, unless the context clearly indicates otherwise.

Spatially relative terms, such as "beneath", "below", "lower", "above", "upper" and the like, may be used herein for ease of description to describe one element or feature's relationship to another element(s) or feature(s) as shown in the figures.

It will be further understood that the terms "includes" and/or "including", when used in this specification, specify the presence of stated features, integers, steps, operations, elements, and/or components, but do not preclude the presence or addition of one or more other features, integers, steps, operations, elements, components, and/or groups thereof.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, embodiments of the present disclosure will be described with reference to accompanying drawings.

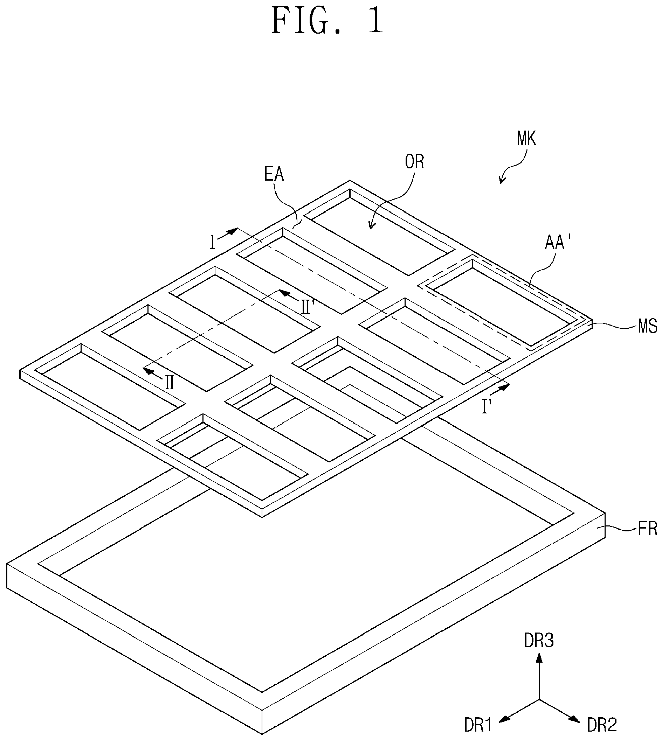

FIG. 1 is an exploded perspective view showing a mask MK according to an embodiment of the present disclosure.

Referring to FIG. 1, the mask MK may be used for a deposition process of a deposition material. According to the embodiment, the mask MK may include a mask frame FR and a mask sheet MS. The mask MK according to an embodiment may be, but not limited to, an open mask for a thin film process. The open mask for the thin film process may be a mask used to stack a thin film layer of the same material over an individual display device on a target substrate.

An upper surface of each element (e.g., mask sheet, mask frame) may be substantially parallel to a plane defined by a first direction DR1 and a second direction DR2. A third direction DR3 indicates a thickness direction of each element. An upper side (in other words, upper portion) and a lower side (in other words, lower portion) of each element are distinguished by the third direction DR3. However, directions of the first, second, and third directions DR1, DR2, and DR3 are relative to each other and are changed to other directions.

The mask frame FR may have a ring shape when viewed in a plane (i.e., in a plan view). That is, an opening may be defined in an area including a center of the mask frame FR. The opening may be a hole penetrating from an upper surface of the mask frame FR to a lower surface of the mask frame FR. In an embodiment, mask frame FR may have a rectangular, hollow shape with a rectangular, empty space therein.

FIG. 1 shows a quadrangular ring shape as a representative shape of the mask frame FR, however, the shape of the mask frame FR according to the invention should not be limited thereto or thereby. In another embodiment, for example, the mask frame FR may have other shapes, e.g., a circular ring shape, a polygonal ring shape, etc. FIG. 1 shows a structure in which the mask frame FR is disposed under the mask sheet MS and supports the mask sheet MS, however, the mask frame FR and the mask sheet MS according to the invention should not be limited thereto or thereby. According to another embodiment, the mask frame FR may be disposed on and under an edge of the mask sheet MS, may support the mask sheet MS, and may elongate the mask sheet MS in the first direction DR1 and the second direction DR2.

The mask sheet MS according to an embodiment may be provided with a plurality of open areas OR defined therethrough and arranged in the first direction DR1 and the second direction DR2. In the present embodiment in FIG. 1, ten open areas OR are arranged in five columns (i.e., two consecutive open areas in the second direction DR2 may compose one column of the open areas) in the first direction DR1, and two rows (i.e., five consecutive open areas in the first direction DR1 may compose one row of the open areas) in the second direction DR2. The open areas OR are spaced apart from each other. However, this is merely illustrative. That is, the mask sheet MS may include more than ten open areas OR, the open areas OR may be arranged in only one direction of the first direction DR1 and the second direction DR2, and, they should not be particularly limited. The mask sheet MS may include the plural open areas OR to stack a plurality of thin film layers having the same material.

The mask sheet MS according to an embodiment may have a plate shape extending in the first direction DR1 and the second direction DR2. The mask sheet MS may define the open areas OR therein and include an extension area EA surrounding each of the open areas OR, and thus, the mask sheet MS may have the single unitary (i.e., monolithic) plate shape. The mask sheet MS according to an embodiment may have the plate shape extending in each of the first direction DR1 and the second direction DR2 rather than having a stick shape extending in only one direction of the first direction DR1 and the second direction DR2. However, the invention should not be limited thereto or thereby. According to another embodiment of the present disclosure, the mask sheet MS may have a stick shape extending in one direction of the first direction DR1 and the second direction DR2 and spaced apart from each other in the other direction of the first direction DR1 and the second direction DR2.

The mask sheet MS and the mask frame FR may have a coefficient of thermal expansion equal to or smaller than about 5 parts per million per degree Centigrade (ppm/°C). According to an embodiment, the mask sheet MS and the mask frame FR may be formed of or include the same material. For example, the mask sheet MS and the mask frame FR may include an alloy of iron (Fe) and nickel (Ni). The alloy of iron (Fe) and nickel (Ni) may contain approximately 36 percentages (%) nickel and 64% iron to have the coefficient of thermal expansion equal to or smaller than about 5 ppm/°C, however, the invention should not be limited thereto or thereby. As another way, the iron-nickel alloy may contain approximately 30 to 40% nickel to have the coefficient of thermal expansion equal to or smaller than about 5ppm/°C.

According to an embodiment, the mask sheet MS and the mask frame FR may include nickel and iron and may further include cobalt (Co). In this case, each of the mask sheet MS and the mask frame FR may contain approximately 5% cobalt (Co).

The mask sheet MS and the mask frame FR may be formed to have the coefficient of thermal expansion equal to or smaller than about 5ppm/°C (parts per million/°C), and thus, a process variation that may occur in a manufacturing process of the mask MK and a deposition process of the display device using the mask MK may be effectively minimized. For example, when the mask sheet MS and the mask frame FR, which have the coefficient of thermal expansion equal to or smaller than about 5ppm/°C, are used, process errors caused by the open areas OR that is deformed due to tension of the mask sheet MS in a process of tensioning the mask sheet MS may be reduced. Referring to Table 1, a variation in a cell position accuracy ("CPA") in the manufacturing process of the mask including the mask sheet MS and the mask frame FR, which contain approximately 36% nickel and approximately 64% iron to have the coefficient of thermal expansion equal to or smaller than about 5ppm/°C, is shown. Here, "5ppm/°C" means "5 µm/(m°C)".

**Table 1**

| | | CPA variation (µm) | | | |
|---|---|---|---|---|---|
| Material | | Invar 36 | Invar 42 | SUS 430 | SUS 304 |
| Coefficient of thermal expansion (CTE, µm/(m°C)) | | 1.6 | 5.8 | 10.4 | 18.8 |
| Mask 1 | Chamber 1 | 4.3 | 15.7 | 28.1 | 50.8 |
| | Chamber 2 | 10.1 | 36.6 | 65.6 | 118.6 |
| Mask 2 | Chamber 1 | 1.5 | 5.6 | 10.0 | 18.1 |
| | Chamber 2 | 3.6 | 13.0 | 23.3 | 42.1 |

In Table 1, the CPA may be an indicator for an accuracy of the open areas OR. The CPA variation may correspond to the process errors with respect to the open areas OR of the mask sheet MS, which occur in the manufacturing process of the mask, e.g., the tensioning process. The coefficient of thermal expansion ("CTE") may correspond to coefficient of thermal expansion of the mask sheet MS and the mask frame FR. The mask 1 and the mask 2 may correspond to masks of different types. The chamber 1 may be a chamber in which an inside temperature of a deposition unit is about 1.5°C, and the chamber 2 may be a chamber in which the inside temperature of the deposition unit is about 3.5°C. Table 1 shows the CPA variation of two masks each of which includes the mask sheet MS and the mask frame FR having a specific coefficient of thermal expansion CTE while the inside temperature is changed from about 1.5°C to about 3.5°C.

Invar 36 corresponds to an alloy containing approximately 36% nickel and approximately 64% iron according to the embodiment of the present disclosure, and, as a comparative example, Invar 42 corresponds to an alloy containing approximately 42% nickel and approximately 58% iron. The coefficient of thermal expansion of Invar 36 is about 1.65 µm/(m°C) that is smaller than about 5 µm/(m°C), and the coefficient of thermal expansion of Invar 42 is about 5.8 µm/(m°C) that is greater than about 5 µm/(m°C). The CPA variation of Invar 36 is smaller than that of Invar 42.

For example, as shown in mask 1, when a temperature variation in the chamber is in a range from about 1.5°C to about 3.5°C, the CPA variation of Invar 36 may be in a range from about 4.3 µm to about 10.1 µm. In the comparative example, the CPA variation of Invar 42 may be in a range from about 15.7 µm to about 36.6 µm on the same condition.

SUS 430 may correspond to an alloy having the coefficient of thermal expansion of about 10.4 µm/(m°C) and containing iron with about 16% to about 18% chromium, and as trace elements, manganese (Mn) (≤1.0%), silicon (Si) (≤0.75%), nickel (Ni) (≤0.6%), carbon (C) (≤0.12%), phosphorus (P), and sulfur (S). SUS 304 may correspond to an alloy having the coefficient of thermal expansion of about 18.8 µm/(m°C) and containing iron with about 18% to about 20% chromium, about 8% to about 10.5% nickel, and as trace elements, manganese (Mn) (≤2.0%), silicon (Si) (≤1.0%), carbon (C) (≤0.07%), phosphorus (P), and sulfur (S).

In Table 1, as shown in mask 1, when the temperature variation in the chamber is in a range from about 1.5°C to about 3.5°C, the CPA variation of the comparative example including SUS 304 is in a range from about 50.8 µm to about 118.6 µm, which is greater than that of the embodiment of the present disclosure.

Therefore, the CPA variation of the embodiment of the present disclosure may be smaller than that of the comparative example, and the process errors may be reduced.

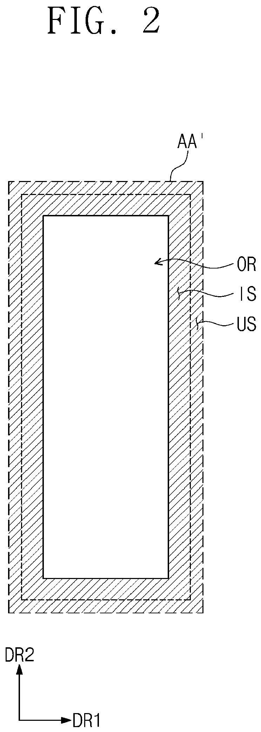

FIG. 2 is a plan view showing the mask sheet according to an embodiment of the present disclosure. FIG. 2 is an enlarged view showing an area AA' of FIG. 1.

Referring to FIG. 2 the open areas OR of the mask sheet MS may be defined by an inner side surface IS of the mask sheet MS. The mask sheet MS may include a plurality of inner side surfaces IS defining the plural open areas OR therein, respectively. The inner side surfaces IS may extend from an upper surface US of the mask sheet MS. The upper surface US of the mask sheet MS may define the extension area EA. Since each of the open areas OR is defined as a rectangular shape, the inner side surfaces IS may include four surfaces for each open area OR.

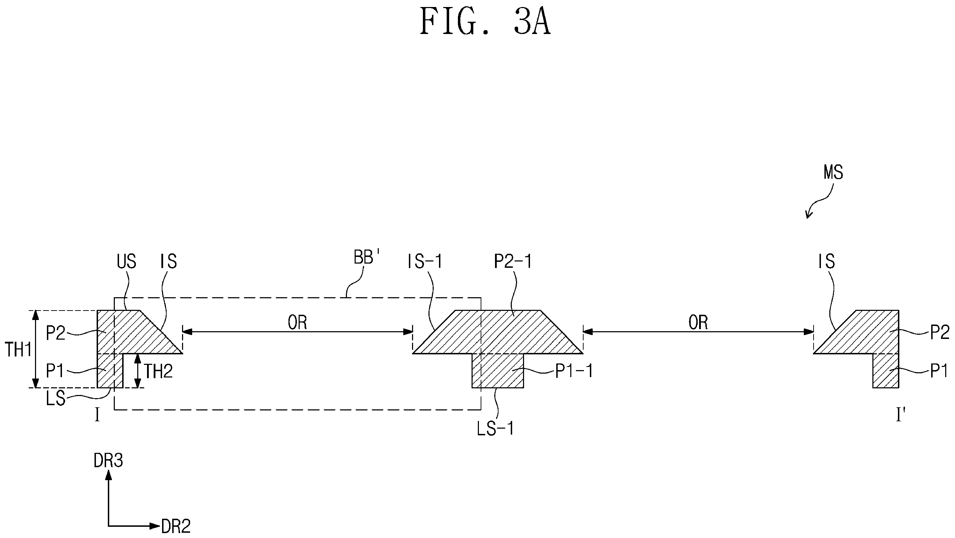

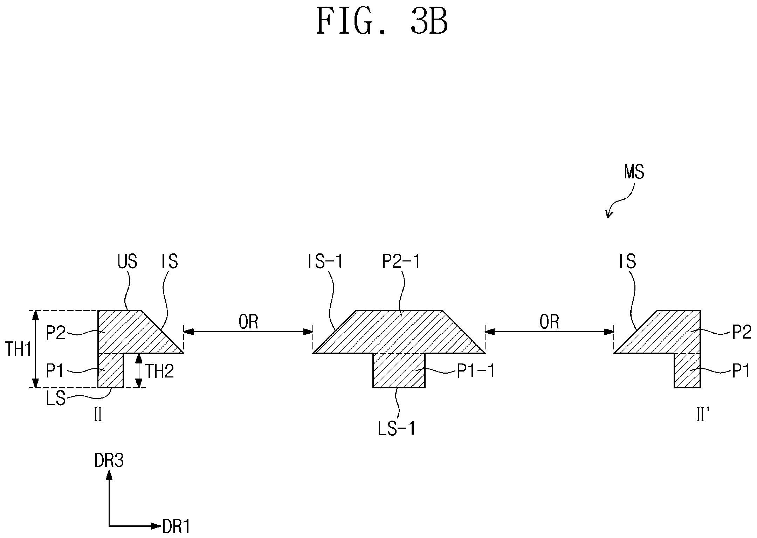

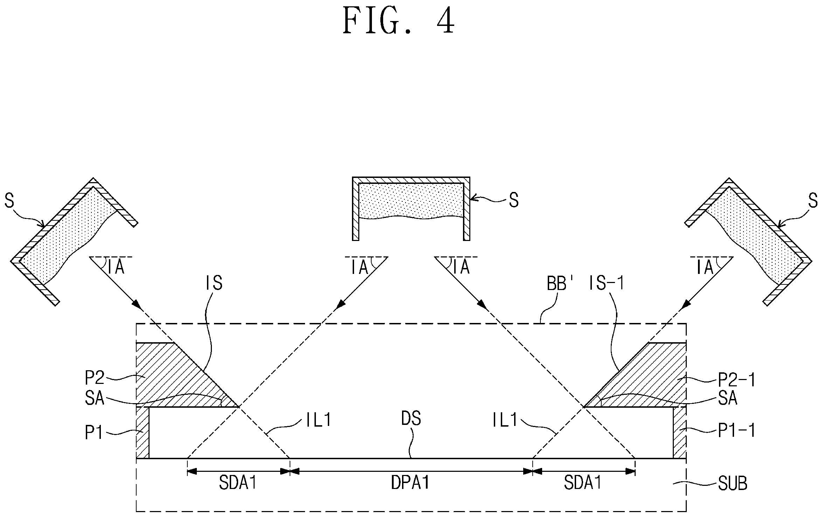

FIGS. 3A and 3B are cross-sectional views showing the mask sheet MS according to an embodiment of the present disclosure. FIG. 3A is a cross-sectional view taken along line I-I' of FIG. 1, and FIG. 3B is a cross-sectional view taken along line II-II' of FIG. 1. FIG. 4 is an enlarged view showing an area BB' of FIG. 3A.

Referring to FIGS. 3A and 3B, the mask sheet MS is shown in three pieces. Referring to FIG. 1, the three pieces are spaced apart from each other with the open area OR interposed therebetween when viewed in a cross-section but are connected to each other by the extension area EA when viewed in a plane (i.e., in a plan view). The upper surface US of each piece may define the extension area EA in a plane defined by the first and second directions DR1 and DR2.

The mask sheet MS may have a thickness TH1 from about 20 µm to about 200 µm. Preferably, the thickness TH1 of the mask sheet MS may be equal to or smaller than about 100 µm. In this case, the thickness may mean a length in the third direction DR3. As the thickness of the mask sheet MS decreases, a shadow occurring in a deposition surface may be reduced.

According to an embodiment, the mask sheet MS may include a first portion P1 and a second portion P2 in a cross-section. The first portion P1 may correspond to a portion that is disposed on a target substrate when the mask MK (refer to FIG. 1) is seated on the target substrate to form a deposition pattern. The first portion P1 may include a first surface LS. The first surface LS may be a lower surface of the mask sheet MS. The lower surface LS may be in contact with the target substrate. The lower surface LS may be disposed on an inactive area of the target substrate. The second portion P2 may be disposed on the first portion P1. The second portion P2 may extend from a top of the first portion P1. In detail, the second portion P2 may extend from the upper surface of the first portion P1 to the open area OR in the second direction DR2.

The second portion P2 may include a second surface IS corresponding to the inner side surface IS of the mask sheet MS. The second surface IS may define the open areas OR. The second surface IS may be a closed-loop surface defining the open areas OR therein. The second surface IS may be an inclined surface with respect to the thickness direction DR3. The second surface IS may be the inclined surface inclined downward toward the open area OR. That is, the thickness of the second portion P2 gradually decreases in a direction away from the first portion P1 to the open area OR (i.e., the first direction DR1 (refer to FIG. 3B) or the second direction DR2 (refer to FIG. 3A)) such that second surface IS may be the inclined surface inclined downward toward the open area OR. That is, the second surface may be an inclined surface inclined downward with respect to the first direction DR1 or the second direction DR2. According to an embodiment, the second surface IS may be formed by irradiating a laser beam onto a preliminary mask sheet.

The first portion P1 may have a thickness TH2 in the thickness direction DR3 smaller than a half of the thickness TH1 of the mask sheet MS. That is, a thickness of the second portion P2 may be greater than the thickness TH2 of the first portion P1. For example, when the thickness TH1 of the mask sheet MS is about 100 µm, the thickness TH2 of the first portion P1 may be in a range from about 20 µm to about 40 µm. As the thickness TH2 of the first portion P1 decreases, the inclined surface IS of the mask sheet MS may become closer to the target substrate SUB (refer to FIG. 4). As the inclined surface IS becomes closer to the target substrate SUB in the third direction DR3, a size of a shadow area SDA1 (refer to FIG. 4) may be reduced.

According to an embodiment, the open areas OR may include a first open area and a second open area adjacent to the first open area. A second portion P2-1 of the mask sheet MS that separates the first open area from the second open area adjacent to first open area may include two second surfaces IS-1 symmetrical with each other. The second surfaces IS-1 may be inclined surfaces that are inclined in directions symmetrical with each other. The second surfaces IS-1 may be symmetrical with each other with respect to a first portion P1-1. The two second surfaces IS-1 may correspond to the inner side surfaces that define the first open area and the second open area, respectively. The first portion P1-1 may include a first surface LS-1. The first surface LS-1 may be a lower surface of the mask sheet MS.

Referring to FIG. 4, when a deposition material is discharged from a deposition source S, the deposition material is deposited on the target substrate SUB after passing through the open areas OR of the mask sheet MS at a predetermined angle. The deposition material deposited on the target substrate SUB may form a thin film layer of an organic light emitting diode.

The deposition surface DS may correspond to a portion of the target substrate SUB, on which the deposition material is deposited. The deposition surface DS may overlap the open area OR and may be formed on a deposition area DPA1 of the target substrate SUB in a plan view. In the deposition process, a deposition material incident at a deposition incident angle IA, which is measured with respect to the plane defined by the first and second directions DR1 and DR2, may be blocked by the second portion P2 or P2-1 of the mask sheet MS. Accordingly, the shadow area SDA1 where the deposition material is not sufficiently deposited may be formed on a portion of the target substrate SUB which is adjacent to the second portion P2 or P2-1 of the mask sheet MS and overlaps the open area OR. Due to the shadow area SDA1, a size or width of the deposition area DPA1 is smaller than a size or width of the open area OR (refer to FIG. 3A). The shadow area SDA1 may cause a dead space in which the organic light emitting diode is not sufficiently formed. This may lead to a decrease of the active area and an increase of the inactive area and may spoil an appearance of the display device.

According to the embodiment of the present disclosure, the second portion P2 or P2-1 of the mask sheet MS, which blocks the deposition material incident at the deposition incident angle IA, may include the inclined surface IS or IS-1 inclined at an inclination angle SA with respect to the plane defined by the first and second directions DR1 and DR2 and which is equal to or smaller than the deposition incident angle IA.

According to the embodiment, the inclination angle SA of the inclined surface IS may be in a range from about 30 degrees (°) to about 70 degrees, preferably, about 45 degrees. In more detail, the inclination angle SA of the second surface IS corresponding to the inner side surface that defines the open areas OR of the mask sheet MS may be formed at an angle from about 30 degrees to about 70 degrees. The inclined surface IS having the inclination angle SA of about 30 degrees to about 70 degrees may be formed by irradiating the laser beam. The size of the shadow area SDA1 occurring at the inclination angle SA of about 30 degrees to about 70 degrees may be smaller than the size of the shadow area SDA1 occurring at the inclination angle SA greater than about 70 degrees (See Table 2). In this case, the size of the shadow area SDA1 may be understood as including the width of the shadow area SDA1. The width of the shadow area SDA1 may correspond to a length in the first direction DR1 or the second direction DR2 of the shadow area SDA1 when viewed in a plane (i.e., in a plan view).

When the deposition material is sputtered onto the mask sheet MS from the deposition source S and deposited on the target substrate SUB through the mask MK, the deposition incident angle IA that is an angle at which the deposition material is provided to the mask sheet MS may be about 45 degrees. According to an embodiment, the inclination angle SA of the second surface IS of the mask sheet MS may be equal to about 45 degrees (i.e., the same as the deposition incident angle IA) or smaller than about 45 degrees. For example, the inclination angle SA may be equal to or greater than about 30 degrees and equal to or smaller than about 45 degrees. The size of the shadow area SDA1 may be constant regardless of the inclination angle SA when the inclination angle SA is equal to or smaller than about 45 degrees that corresponds to the deposition incident angle IA (See Table 2).

An incident line IL1, which is a movement path that the deposition material is provided along the inclined surface IS with the deposition incident angle IA, may cross another incident line through which the deposition material is provided to the inclined surface, and the incident line IL1 and the another incident line may define the shadow area SDA1. Referring to Table 2, a variation in the size (or width) of the shadow area SDA1 depending on the variation of the inclination angle SA according to the embodiment of the present disclosure is shown. Table 2 shows a result of a process in which the deposition material is discharged to the substrate from the deposition source S disposed at a specific position to sputter the deposition material onto the substrate SUB. Table 2 shows the sizes of the shadow areas SDA1 generated at various measurement positions (position 1 to position 5) on the substrate SUB. In this case, the measurement positions may correspond to five shadow areas SDA1 spaced apart from each other at regular intervals and disposed at different positions among the shadow areas SDA1 generated on the substrate.

**Table 2**

| | | Size of shadow area (SDA1) (µm) | | | |
|---|---|---|---|---|---|
| Inclination angle (SA) | | 30 degrees | 45 degrees | 70 degrees | 90 degrees |
| Measurement position | Position 1 | 105 | 105 | 107 | 138 |
| | Position 2 | 105 | 105 | 121 | 150 |
| | Position 3 | 102 | 102 | 130 | 160 |
| | Position 4 | 104 | 104 | 143 | 172 |
| | Position 5 | 105 | 105 | 155 | 185 |

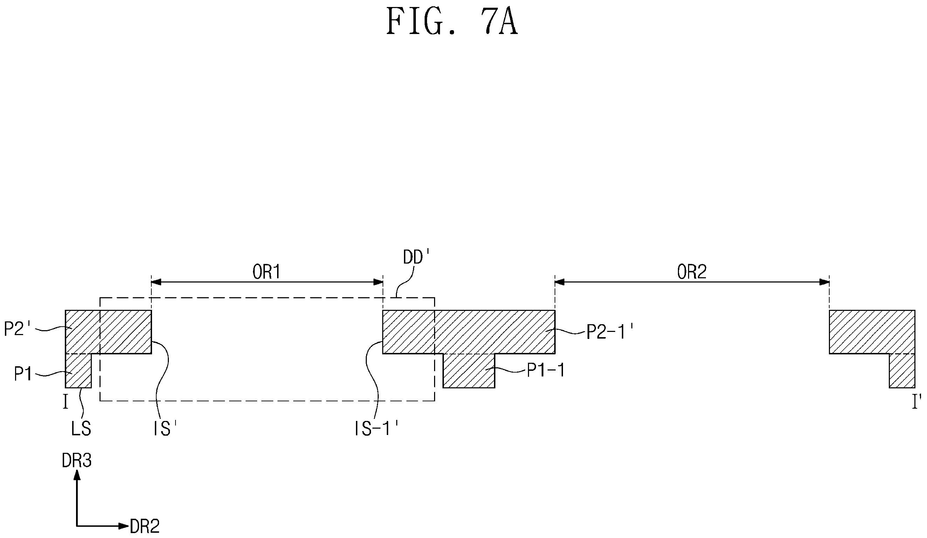

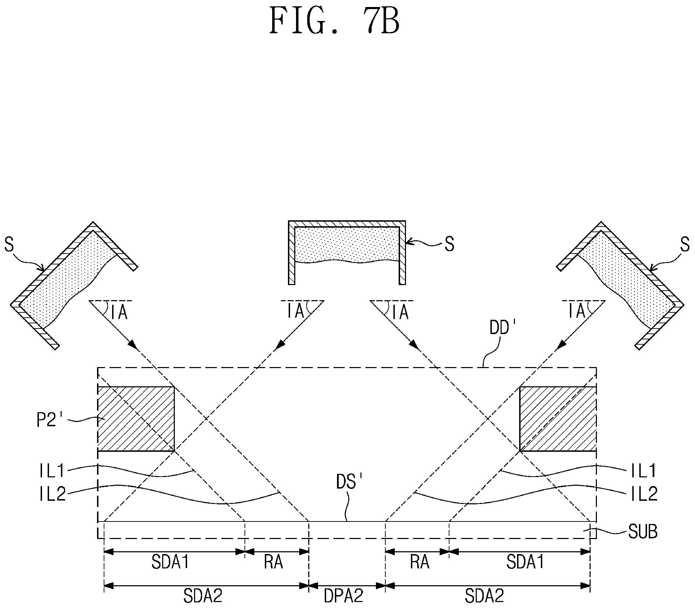

In Table 2, when the inclination angle SA of the inclined surface IS is in a range from about 30 degrees to about 70 degrees, the size of the shadow area SDA1 is smaller than the size of the shadow area SDA1 when the inclination angle SA is about 90 degrees. When the inclination angle SA is about 70 degrees, the size of the shadow area SDA1 at position 1 is about 107 µm similar to the size (about 105 µm) of the shadow area SDA1 when the inclination angle SA is equal to or smaller than about 45 degrees. When the inclination angle SA is equal to or smaller than about 45 degrees, the size of the shadow area SDA1 is smaller than the size of shadow area SDA1 when the inclination angle SA is about 70 degrees. When the inclination angle SA of the inclined surface IS is equal to or smaller than about 45 degrees, i.e., when the inclination angle SA of the inclined surface IS is equal to or smaller than the deposition incident angle IA, the size of the shadow area SDA1 is constant regardless of the inclination angle SA. That is, results measured when the inclination angle SA is in a range from about 30 degrees to about 70 degrees show the embodiment of the present disclosure, and results measured when the inclination angle SA is about 90 degrees show the comparative example. Referring to Table 2, the size of the shadow area SDA1 of the mask sheet MS having the inclination angle SA according to the embodiment of the present disclosure (i.e., the inclination angle SA is in a range from about 30 degrees to about 70 degrees) may be smaller than the size of shadow area SDA1 according to the comparative example (i.e., the inclination angle SA is about 90 degrees). That is, when the inclination angle SA is equal to or smaller than the deposition incident angle IA, an amount of the deposition material blocked by the mask sheet MS may be reduced, and thus, the size of the shadow area SDA1 may be effectively reduced. This will be described in detail with reference to FIGS. 7A and 7B.

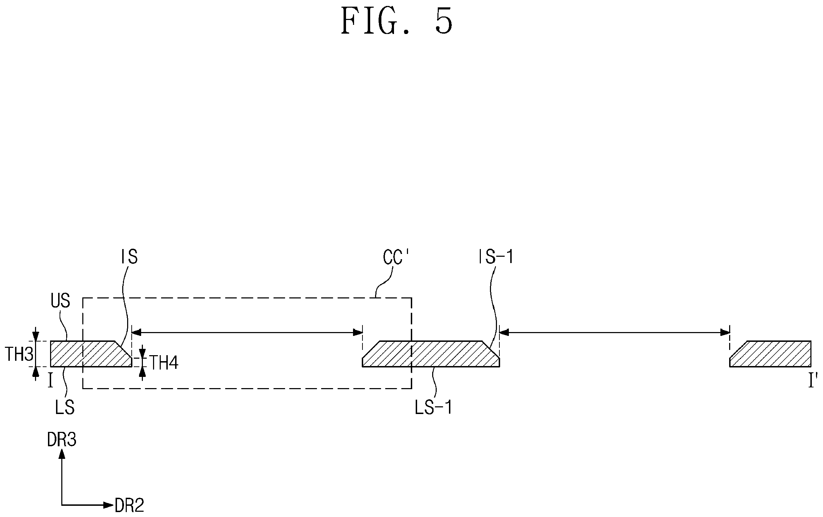

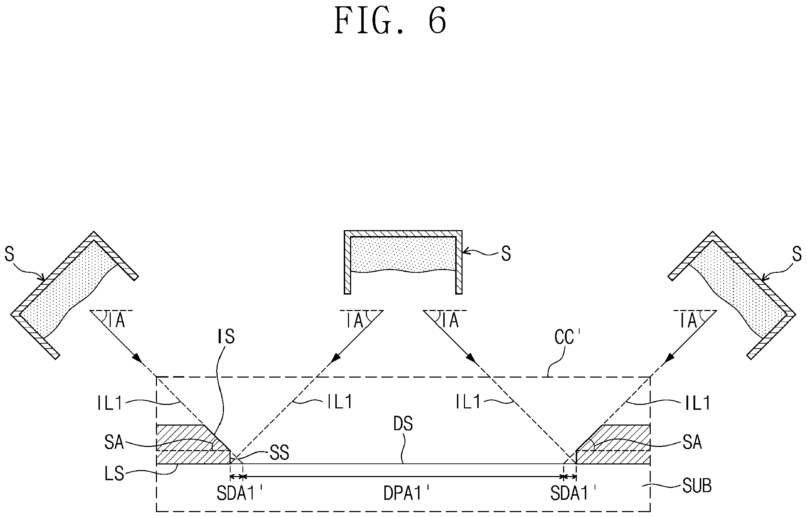

FIG. 5 is a cross-sectional view showing a mask sheet according to another embodiment of the present disclosure. FIG. 5 shows a cross-section taken along line I-I' of FIG. 1 according to another embodiment. FIG. 6 is an enlarged view showing an area CC' of FIG. 5.

Referring to FIGS. 5 and 6, the mask sheet MS may include an upper surface US, a first surface LS opposite to the upper surface US and making contact with the target substrate SUB, and a second surface IS or IS-1 defining the open areas OR. The mask sheet MS may include a third surface SS defined between the first surface LS and the second surface IS or IS-1.

The mask sheet MS according to the embodiment may have a thickness TH3 equal to or smaller than about 100 µm in the thickness direction DR3. Preferably, the thickness TH3 may be in a range from about 20 µm to about 30 µm. A length TH4 in the third direction DR3 of the third surface SS may be equal to or smaller than a half of the thickness TH3 of the mask sheet MS. For example, when the thickness TH3 of the mask sheet MS is about 30 µm, the length TH4 in the third direction DR3 of the third surface SS may be equal to or smaller than about 15 µm.

In the present embodiment, an inclination angle SA of the second surface IS or IS-1 may be in a range from about 30 degrees to about 70 degrees, preferably, about 45 degrees. In the mask sheet MS according to the present embodiment, the inclined surface IS having the inclination angle SA of about 45 degrees may be disposed close to the target substrate SUB, and thus, a size of a shadow area SDA1' may be further reduced and a size of a deposition area DPA1' may be further increased compared to the embodiment in FIGS. FIGS. 3A, 3B, and 4. In FIGS. 5 and 6, the same descriptions as those of FIGS. 3A, 3B, and 4 are omitted.

FIG. 7A is a cross-sectional view showing a mask sheet according to a comparative example, and FIG. 7B is an enlarged view showing an area DD' of FIG. 7A.

In FIG. 7A, the mask sheet may not have a coefficient of thermal expansion equal to or smaller than about 5ppm/°C. In the mask sheet having the coefficient of thermal expansion greater than about 5ppm/°C according to the comparative example, a plurality of open areas OR1 and OR2 may have different sizes from each other. This is because degrees of tension of the open areas are different from each other when the mask sheet is tensioned. For example, in the comparative example, a first open area OR1 may have different size or width from that of a second open area OR2.

In FIG. 7B, the mask sheet according to the comparative example does not include an inclined surface. In more detail, the mask sheet according to the comparative example does not include a second portion P2 including the inclined surface having the inclination angle in a range from about 30 degrees to about 70 degrees. Rather, an inner side surface IS' or IS-1' of a second portion P2' or P2-1' of the mask sheet may be substantially perpendicular to the target substrate SUB. That is, the inner side surface IS' or IS-1' of the mask sheet according to the comparative example may have the inclination angle of about 90 degrees. a size of a shadow area SDA2 according to the comparative example may have a value from about 138 µm to about 185 µm depending on a measurement position.

The deposition material discharged from the deposition source S is provided to the open area OR1 or OR2 after passing the mask sheet at the deposition incident angle of about 45 degrees. In the comparative example, the deposition material may be incident to the target substrate SUB along a second incident line IL2. In the mask sheet MS (refer to FIG. 4) according to the embodiment in FIG. 4 or 6, the deposition material is provided through the first incident line IL1 after passing the inclined surface IS (refer to FIG. 4) as described above. The size of the shadow area SDA1 formed by the first incident line IL1 is smaller than the size of the shadow area SDA2 formed by the second incident line IL2.

The area of the deposition surface DS (refer to FIG. 4) according to the embodiment in FIG. 4 or 6 is greater than the area of the deposition surface DS' formed in the target substrate SUB according to the comparative example. In FIG. 7B, the area of the deposition surface according to the embodiment in FIG. 4 or 6 is greater than the area of the deposition surface DS' according to the comparative example by a difference area RA between the size of the shadow area SDA2 according to the comparative example and the size of the shadow area SDA1 according to the embodiment in FIG. 4 or 6. A size of the difference area RA may correspond to, for example, about 33 µm as shown in the case of position 1 in Table 2.

That is, since the mask according to the embodiment in FIG. 4 or 6 includes the inclined surface inclined at the angle from about 30 degrees to about 70 degrees, the size of the shadow area may be reduced, and the area of the deposition surface may increase. As a result, the dead space of the display device may be effectively reduced.

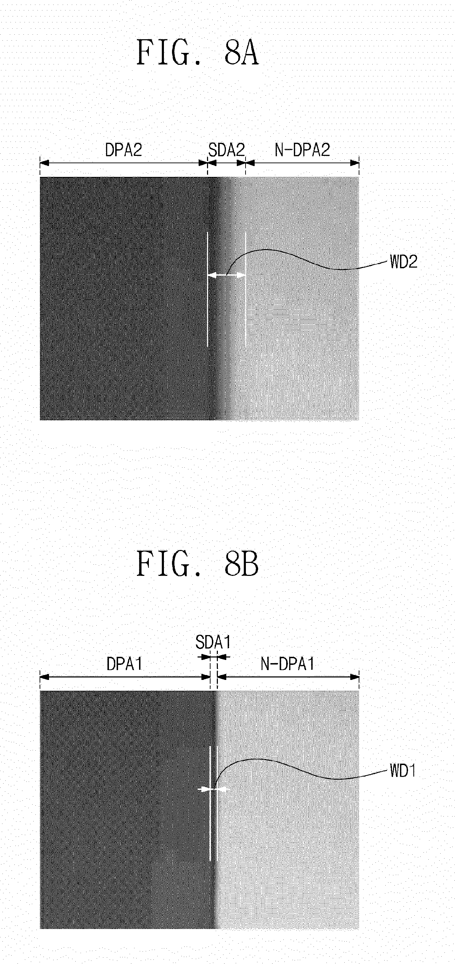

FIGS. 8A and 8B are SEM images showing the deposition portion formed using the mask. FIG. 8A shows a width WD2 of the shadow area SDA2 according to the comparative example. FIG. 8B shows a width WD1 of the shadow area SDA1 according to the embodiment of the present disclosure.

FIG. 8A shows a deposition area DPA2, a non-deposition area N-DPA2, and the shadow area SDA2 defined between the deposition area DPA2 and the non-deposition area N-DPA2 according to the comparative example. FIG. 8B shows a deposition area DPA1, a non-deposition area N-DPA1, and the shadow area SDA1 defined between the deposition area DPA1 and the non-deposition area N-DPA1 according to the embodiment of the present disclosure.

In FIGS. 8A and 8B, it may be observed that the width WD1 of the shadow area SDA1 generated in the mask MK of the present disclosure is smaller than the width WD2 of the shadow area SDA2 generated in the mask according to the comparative example. That is, the size of the deposition area DPA1 shown in FIG. 8B according to the embodiment of the present disclosure may be greater than the size of the deposition area DPA2 shown in FIG. 8A according to the comparative example.

Although the embodiments of the present disclosure have been described, it is understood that the present disclosure should not be limited to these embodiments but various changes and modifications can be made by one ordinary skilled in the art within the scope of the present disclosure as hereinafter claimed. Therefore, the disclosed subject matter should not be limited to any single embodiment described herein, and the scope of the present inventive concept shall be determined according to the attached claims.

## Claims

1. A mask comprising:
a mask sheet provided with a plurality of open areas defined therein in a plan view; and
a mask frame which supports the mask sheet, the mask sheet comprising:
a first portion comprising a first surface, wherein the first surface is configured to be in contact with a target substrate; and
a second portion disposed on the first portion, extending from a top of the first portion in a first direction and comprising a second surface defining the open area,
wherein the second surface is an inclined surface inclined downward with respect to the first direction, and the first direction is parallel to a plane in which the first surface is included.

2. The mask of claim 1, wherein the inclined surface has an inclination angle from about 30 degrees to about 70 degrees.

3. The mask of claim 1 or claim 2, wherein the mask sheet has a coefficient of thermal expansion equal to or smaller than about 5 parts per million per degree Centigrade (ppm/°C).

4. The mask of claim 3, wherein the mask frame has a coefficient of thermal expansion that is the same as the coefficient of thermal expansion of the mask sheet.

5. The mask of any preceding claim, wherein the mask sheet has a thickness from about 20 micrometers (µm) to about 200 µm in a thickness direction of the mask sheet.

6. The mask of any preceding claim, wherein the first portion has a thickness smaller than a half of a thickness of the mask sheet.

7. The mask of any preceding claim, wherein the inclined surface has an inclination angle equal to or smaller than a deposition incident angle, and the deposition incident angle is an angle at which a deposition material to be deposited on the target substrate is provided to the mask sheet.

8. The mask of any preceding claim, wherein the mask sheet comprises an alloy of iron (Fe) and nickel (Ni).

9. The mask of any preceding claim, wherein the plurality of open areas comprise a first open area and a second open area defined adjacent to the first open area, and the second surface comprises two second surfaces that define the first open area and the second open area, respectively.

10. The mask of claim 9, wherein the two second surfaces are disposed to be symmetrical with each other with respect to the first portion.

11. A method of manufacturing a mask, comprising:
forming a mask sheet;
tensioning the mask sheet; and
coupling the mask sheet to a mask frame, the forming of the mask sheet comprising:
preparing a preliminary mask sheet; and
irradiating a laser beam onto the preliminary mask sheet to form a plurality of open areas,
wherein the open areas are defined by an inner side surface of the mask sheet, and the inner side surface is an inclined surface with respect to a major surface plane of the mask sheet.

12. The method of claim 11, wherein the inclined surface has an inclination angle from about 30 degrees to about 70 degrees.

13. The method of claim 11 or claim 12, wherein the mask sheet is configured to deposit a same thin film layer of a same material on a base substrate of an organic light emitting diode over an individual display device.

14. The method of any of claims 11 to 13, wherein the mask sheet and the mask frame have a coefficient of thermal expansion equal to or smaller than about 5 ppm/°C.
